# EUROPÄISCHE PATENTSCHRIFT

(11) **EP 1 808 910 B1**
(45) Veröffentlichungstag und Bekanntmachung des Hinweises auf die Patenterteilung: **16.11.2011**
(21) Anmeldenummer: 06026743.2
(22) Anmeldetag: 22.12.2006
(51) Int. Cl.: H01L 51/52, H01L 51/44

(54) **Elektronisches Bauelement mit mindestens einer organischen Schichtanordnung**
Electronic component with at least one organic layer
Composant électronique doté dýau moins un dispositif de couche organique

(30) Priorität: 11.01.2006 EP 06000436
(43) Veröffentlichungstag der Anmeldung: 18.07.2007
(73) Patentinhaber: Novaled AG, 01307 Dresden (DE)
(72) Erfinder: Schwartz, Gregor, 01159 Dresden (DE); Harada, Kentaro, 164-0001 Tokyo (JP); Werner, Ansgar, Dr., 01277 Dresden (DE); Walzer, Karsten, 01099 Dresden (DE); Pfeiffer, Martin, Dr., 01127 Dresden (DE); Canzler, Tobias, Dr., 01099 Dresden (DE); Zeika, Olaf, 06727 Theissen (DE); Wellmann, Philipp, 64285 Darmstadt (DE)
(74) Vertreter: Bittner, Thomas L.

(56) Entgegenhaltungen:
- EP-A- 1 478 025
- WO-A-2005/109542
- DE-A1- 10 209 789
- US-A1- 2004 067 324
- US-A1- 2006 157 728
- US-A1- 2006 251 922
- US-B1- 6 639 357
- TSUZUKI T ET AL: "The effect of fullerene doping on photoelectric conversion using titanyl phthalocyanine and a perylene pigment" SOLAR ENERGY MATERIALS AND SOLAR CELLS, ELSEVIER SCIENCE PUBLISHERS, AMSTERDAM, NL, Bd. 61, Nr. 1, 15. Februar 2000 (2000-02-15), Seiten 1-8, XP004244744 ISSN: 0927-0248
- SIGNERSKI ET AL: "The photovoltaic effect in a heterojunction of molybdenyl phthalocyanine and perylene dye" JOURNAL OF NON-CRYSTALLINE SOLIDS, NORTH-HOLLAND PHYSICS PUBLISHING. AMSTERDAM, NL, Bd. 352, Nr. 40-41, 1. November 2006 (2006-11-01), Seiten 4319-4324, XP005705518 ISSN: 0022-3093
- PFEIFFER M ET AL: "Controlled p-doping of pigment layers by cosublimation: Basic mechanisms and implications for their use in organic photovoltaic cells", SOLAR ENERGY MATERIALS AND SOLAR CELLS, ELSEVIER SCIENCE PUBLISHERS, AMSTERDAM, NL, vol. 63, no. 1, 1 June 2000 (2000-06-01), pages 83-99, XP004201249, ISSN: 0927-0248, DOI: DOI:10.1016/S0927-0248(00)00022-2
- GEBEYEHU D ET AL: "Bulk-heterojunction photovoltaic devices based on donor-acceptor organic small molecule blends", SOLAR ENERGY MATERIALS AND SOLAR CELLS, ELSEVIER SCIENCE PUBLISHERS, AMSTERDAM, NL, vol. 79, no. 1, 1 August 2003 (2003-08-01) , pages 81-92, XP004446739, ISSN: 0927-0248, DOI: DOI:10.1016/S0927-0248(02)00369-0

## Beschreibung

Die Erfindung bezieht sich auf ein elektronisches Bauelement, insbesondere lichtemittierendes elektronisches Bauelement, mit einer Anode, einer Kathode und mindestens einer organischen Schichtanordnung, die zwischen der Anode und der Kathode angeordnet und in elektrischem Kontakt mit der Anode und der Kathode ist.

### Hintergrund der Erfindung

Solche elektronischen Bauelement sind in verschiedenen Ausführungsformen bekannt. Hierzu gehören beispielsweise organische lichtemittierende Bauelemente wie organische lichtemittierende Dioden (OLED), organische Dioden, organische Solarzellen und organische Transistoren. In einer Ausführung sind auch gestapelte organische lichtemittierende Bauelemente bekannt, bei denen zwischen der Anode und der Kathode mehrere individuelle organische Schichtanordnungen, insbesondere unter Einschluss eines lichtemittierenden Bereiches, gestapelt sind. So sind zum Beispiel OLEDs in gestapelter Bauweise bekannt.

Typischerweise umfasst die organische Schichtanordnung mehrere übereinander angeordnete organische Schichten. Innerhalb der organischen Schichtanordnung können auch ein oder mehrere pn-Übergänge vorgesehen sein, wie dieses für gestapelte OLEDs bekannt ist (vgl. EP 1 478 025 A2, wobei ein solcher pn-Übergang in einer Ausführung mit Hilfe einer p-dotierten Löchertransportschicht und einer n-dotierten Elektronentransportschicht gebildet wird, die in direktem Kontakt miteinander gebildet sind. Ein solcher pn-Übergang stellt eine elektrische Ladungen erzeugende Struktur dar, in welcher beim Anlegen eines elektrischen Potentials elektrische Ladungen erzeugt werden, vorzugsweise im Grenzbereich zwischen den beiden Schichten.

In organischen lichtemittierenden Dioden bekannter Bauform ist bei der Verwendung von dotierten Ladungsträgertransportschichten eine p-dotierte Löchertransportschicht in Kontakt mit der Anode oder einer zwischen der p-dotierten Löchertransportschicht und der Anode angeordneten Löcherinjektionsschicht. Die n-dotierte Elektronentransportschicht ist in Kontakt mit der Kathode oder einer hierzwischen angeordneten Elektroneninjektionsschicht.

Beim Ausbilden einer dotierten organischen Schicht werden ein oder mehrere Dotierungsmaterialien in ein organisches Matrixmaterial eingelagert, bei dem es sich um ein organisches Halbleitermaterial handelt. Eine Schicht wird als p-dotierte organische Schicht bezeichnet, wenn das organische Matrix-Halbleitermaterial Dotanden in Form von Akzeptoren enthält. Eine dotierte Schicht wird als n-dotierte organische Schicht bezeichnet, wenn die eingelagerten Dotanden für das organische Matrixmaterial Donatoren bilden.

Eine elektrische Dotierung im Sinne der vorliegenden Anmeldung entsteht dadurch, dass das eine oder die mehreren eingelagerten Dotierungsmaterialien eine Redoxreaktion mit dem Matrixmaterial ausführen, wodurch es zu einem wenigstens teilweisen Ladungstransfer zwischen dem einen oder den mehreren Dotierungsmaterialien einerseits und dem Matrixmaterial andererseits kommt, d. h. eine Übertragung von elektrischen Ladungen zwischen den Materialien findet statt. Auf diese Weise werden (zusätzliche) freie Ladungsträger in der Schicht gebildet, welche ihrerseits die elektrische Leitfähigkeit der Schicht erhöhen. Es entsteht in dem Matrixmaterial eine höhere Dichte von Ladungsträgern im Vergleich zum undotierten Material. Es besteht der folgende physikalische Zusammenhanges für die elektrische Leitfähigkeit: Ladungsträgerdichte x Beweglichkeit der Ladungsträger = elektrische Leitfähigkeit. Der mittels der Redoxreaktion gebildete Teil der Ladungsträger in dem Matrixmaterial muss nicht erst aus einer Elektrode injiziert werden, vielmehr stehen solche Ladungsträger infolge der elektrischen Dotierung schon in der Schicht zur Verfügung.

Ein Halbleitermaterial wird andererseits als Halbleitermaterial vom p-Typ bezeichnet, wenn es in der Lage ist, Ladungsträger in Form von Löchern zu transportieren, d. h. die Mobilität (Beweglichkeit) für die Löcher ist in dem Halbleitermaterial für den Transport ausreichend. In analoger Weise wird ein Halbleitermaterial als Halbleitermaterial vom n-Typ bezeichnet, wenn es in der Lage ist, Ladungsträger in Form von Elektronen zu transportieren, d. h. die Mobilität (Beweglichkeit) für Elektronen in dem Material ist für den Transport ausreichend.

Zur Verbesserung der energetischen Eigenschaften in einem organischen elektronischen Bauelement wurde in dem Dokument WO 2005/109542 A1 vorgeschlagen, mit einer Schicht aus einem organischen Halbleitermaterial vom n-Typ und einer Schicht aus einem organischen Material vom p-Typ einen pn-Übergang zu bilden, wobei die Schicht aus dem organischen Halbleitermaterial vom n-Typ mit einer als Anode ausgeführten Elektrode in Kontakt ist. Auf diese Weise wird eine verbesserte Injektion von Ladungsträgern in Form von Löchern in die Schicht aus dem organischen Halbleitermaterial vom p-Typ erreicht.

In dem Dokument Tsuzuki et al. ("The effect of fullerene doping on photoelectric conversion using titanyl phthalocyanine and a perylene pigment", Solar Energy Materials and Solar Cells, Elsevier Science Publishers, Amsterdam, NL, Bd. 61, Nr. 1, Seiten 1-8, 15. Februar 2000) ist ein photovoltaisches Bauelement offenbart, bei dem in einer Ausfiihrungsform Elektroden aus Gold und ITO gebildet sind. Ein Photostrom fließt von der Goldelektrode zu der ITO-Elektrode durch einen äußeren Stromkreis in einer Richtung entgegengesetzt zu dem Dunkelstrom, wodurch im Ergebnis lichtgenerierte Elektronen und Löcher sich zu der ITO-Elektrode bzw. der Goldelektrode bewegen.

In dem Dokument von Signerski et al. ("The photovoltaic effect in a heterojunction of molybdenyl phthalocyanine and perylene dye", Journal of Non-Crystalline Solids, Nörth-Holland Physics Publishing, Amsterdam, NL, Bd. 352, Nr. 40-41, Seiten 4319-4324, 1. November 2006) wird über einen photovoltaischen Effekt in einem Heteroübergang berichtet.

### Zusammenfassung der Erfindung

Aufgabe der Erfindung ist es, ein elektronisches Bauelement mit einer Anode, einer Kathode. und mindestens einer organischen Schichtanordnung zwischen der Anode und der Kathode mit verbesserten Betriebseigenschaften zu schaffen.

Diese Aufgabe wird erfindungsgemäß durch ein elektronisches Bauelement nach dem unabhängigen Anspruch 1 gelöst.

Erfindungsgemäß ist ein elektronisches Bauelement, welches als organische Diode ausgeführt ist, mit einer eine leitende Schicht aufweisenden Anode, einer eine leitende Schicht aufweisenden Kathode und mindestens einer organischen Schichtanordnung, die zwischen der Anode und der Kathode angeordnet und in elektrischem Kontakt mit der Anode und der Kathode ist und einen Bereich mit einem pn-Übergang aufweist, welcher konfiguriert ist, beim Anlegen des elektronischen Potentials an die Anode und die Kathode benachbart zu der Kathode elektrische Ladungen zu erzeugen, und welcher, mit einer Schicht aus einem organischen Halbleitermaterial vom n-Typ und einer p-dotierten Schicht aus einem organischen Halbleitermaterial vom p-Typ gebildet ist, wobei die p-dotierte Schicht mit der leitenden Schicht der Kathode in Kontakt ist.

Es wurde gefunden, dass mit Hilfe des np- / pn-Übergangs eine effiziente Erzeugung von freien Ladungsträgern in der organischen Schichtanordnung benachbart zu einer oder beiden Elektroden (Anode, Kathode) ermöglicht ist. Beim Anlegen eines elektrischen Potentials an die Anode und die Kathode kommt es insbesondere im Übergangsbereich zwischen den den Übergang bildenden Schichten zur Erzeugung freier Ladungsträger.

Im Vergleich zum Stand der Technik ergibt sich eine Reduzierung der Betriebsspannung aufgrund der mittels Dotierung ausgebildeten Leitfähigkeit. Insbesondere ist es ermöglicht, die Dicke der dotierten Schicht des np- / pn-Überganges in einem großen Bereich zu variieren, ohne das Nachteile beim Transport der Ladungsträger entstehen.

Herkömmliche organische lichtemittierende Bauelemente leiden unter dem Problem, dass die Injektion von einem Ladungsträgertyp, bei dem es sich üblicherweise um die Elektronen handelt, schwieriger ist als die Injektion des anderen Ladungsträgertyps, nämlich der Löcher. Das hat zu Folge, dass die Balance der Ladungsträgerinjektion gestört ist. In vielen Fällen führt dies dazu, dass das Bauelement geringe Stromeffizienzen aufweist, da sich beispielsweise nicht balancierte Raumladungen ausbilden, weil Ladungsträger nicht effizient rekombinieren. In diesem Zusammenhang bringt eine mögliche Ausgestaltung in Form der Verwendung von gleichen pn-Übergängen an der Kathode und der Anode besondere Vorteile. Die Ladungsträgererzeugung erfolgt aufgrund der gleichartigen Struktur beider pn-Übergänge gleich effizient für die Bereitstellung sowohl von Elektronen als auch von Löchern. Dies führt zu einer Verbesserung der Ladungsträgerbalance und damit der Effizienz von Lichtemission in dem Bauelement.

Weiterhin erlaubt die vorgeschlagene Nutzung von pn-Übergängen die Verwendung von Kontaktmaterialien, die in herkömmlichen organischen lichtemittierenden Dioden nicht in Frage kommen. So ist es beispielsweise möglich, Au oder ITO als Deckelektrode in Form einer Kathode, d. h. während des Betrieb des Bauelementes ist dieser Kontakt mit dem negativen Pol der Spannungsquelle verbunden, auszuführen. Wenn bestimmte Elektrodenmaterialien aus technischen Gründen gewünscht sind, aber in herkömmlichen Bauelementstrukturen Inkompatibilitäten zu den üblichen organischen Materialien für Ladungsträgertransportschichten auftreten, wie zum Beispiel chemische Reaktionen oder die Diffusion von Atomen oder Ionen, erlaubt die vorgeschlagene Verwendung eines pn-Überganges oder von zwei pn-Übergängen mehr Freiheit bei der Auswahl von Metallen oder Transportmaterialien. Beispielsweise ist es möglich, Metalle mit einer niedrigen Austrittsarbeit von kleiner als 5.1eV und bevorzugt von kleiner als 4.5eV wie zum Beispiel A1 oder Ag als Anode zu verwenden. Gleichfalls kann vorgesehen sein, Metalle mit einer hohen Austrittsarbeit von größer als 4.2eV wie beispielsweise Au oder ITO als Kathode zu verwenden. Weiterhin ist es ermöglicht, Löchertransportmaterialien in Verbindung mit der Kathode zu verwenden und / oder Elektronentransportmaterialien in Verbindung mit der Anode. Auf diese Weise ist es erleichtert, geeignete, kompatible Kontaktmaterialien und organische Transportmaterialien zu kombinieren.

Ein großes Problem bei der Verwendung von organischen lichtemittierenden Bauelementen ist es, dass sich die so genannte invertierte Struktur nur schwer realisieren lässt. Bei dieser Struktur befindet sich die Kathode auf dem Substrat und die Anode bildet einen Deckkontakt. Solche Strukturen sind herkömmlich durch eine deutlich höhere Betriebsspannung und eine geringere Lebensdauer im Vergleich zu einer verwandten nicht-invertierten Struktur gekennzeichnet. Die Verwendung eines pn-Überganges oder von zwei pn-Übergängen verbessert die Eigenschaften der invertierten Struktur. Ursache ist, dass die in den nicht-invertierten Strukturen verwendeten Elektrodenmaterialien für die Anode und die Kathode, beispielsweise ITO für die Anode und Ag oder Al für die Kathode, weiterhin in der selben Position des Bauelementes verbleiben können, nämlich als Grund- und Deckkontakt, jedoch in Verbindung mit dem pn-Übergang oder dem pn-Übergängen als Kathode und Anode in einer invertierten Struktur funktionieren.

Für ein organisches Halbleitermaterial vom p-Typ ist es vorteilhaft, wenn die Beweglichkeit für Ladungsträger in Form von Löchern größer als 10⁻⁷cm²/Vs und bevorzugt größer als 10⁻⁵ cm²/Vs ist. Weiterhin ist es vorteilhaft, dass das dotierte organische Halbleitermaterial vom p-Typ ein geringes Oxidationspotential von kleiner als 0.5V vs. Fc/Fc⁺, bevorzugt von kleiner als 0V vs. Fc/Fc⁺ und weiter bevorzugt von kleiner als -0.5V vs. Fc/Fc⁺ aufweist. Schließlich ist es vorteilhaft, wenn das dotierte organische Halbleitermaterial vom p-Typ eine elektrische Leitfähigkeit aufweist, die größer als 10⁻⁷ S/cm, bevorzugt größer als 10⁻⁵S/cm und weiter bevorzugt als 10⁻³S/cm ist.

Für ein organisches Halbleitermaterial vom n-Typ ist es vorteilhaft, wenn die Beweglichkeit für Ladungsträger in Form von Elektronen größer als 10⁻⁷cm²/Vs und bevorzugt größer als 10⁻⁵cm²/Vs ist. Weiterhin ist es vorteilhaft, wenn das dotiere organische Halbleitermaterial vom n-Typ ein hohes Oxidationspotential von größer als -2.5V vs. Fc/Fc⁺, bevorzugt von größer als -2.0V vs. Fc/Fc⁺ und weiter bevorzugt von größer als -1.5 V vs. Fc/Fc⁺ ausweist. Schließlich ist es vorteilhaft, wenn das dotierte organische Halbleitermaterial vom n-Typ eine Leitfähigkeit aufweist, die größer als 10⁻⁷S/cm, bevorzugt größer als 10⁻⁵S/cm und weiter bevorzugt größer als 10⁻³S/cm ist.

Es ist weiterhin von Vorteil, wenn die energetische Differenz zwischen dem niedrigsten unbesetzten Molekülorbital (LUMO *- "Lowest Unoccupied Molecular Orbital"*) des Materials der n-dotierten organischen Halbleiterschicht vom n-Typ und dem höchsten besetzten Molekularorbital (HOMO - *"Highest Occupied Molecular Orbital"*) einer angrenzenden Schicht aus einem organischen Halbleitermaterial vom p-Typ kleiner als 1.5eV, bevorzugt kleiner als 1.0eV und weiter bevorzugt kleiner als 0.5eV ist. In Fall, dass die angrenzende organische Halbleiterschicht vom p-Typ ebenfalls dotiert ist, ist es vorteilhaft, wenn die energetische Differenz kleiner als 2.5eV, bevorzugt kleiner als 2.0eV und weiter bevorzugt kleiner als 1.5eV ist.

Ergänzend oder alternativ kann vorgesehen sein, dass die energetische Differenz zwischen dem HOMO der p-dotierten Schicht aus dem organischen Halbleitermaterial vom p-Typ und dem LUMO einer angrenzenden Schicht aus einem organischen Halbleitermaterial vom n-Typ kleiner als 1.5eV, bevorzugt kleiner als 1.0eV und weiter bevorzugt kleiner als 0.5eV ist. Im Fall, dass die angrenzende Schicht aus dem organische Halbleitermaterial vom n-Typ ebenfalls dotiert ist, ist es vorteilhaft, wenn die energetische Differenz kleiner als 2.5eV, bevorzugt kleiner als 2.0eV und weiter bevorzugt kleiner als 1.5eV ist.

Eine bevorzugte Weiterbildung der Erfindung sieht vor, dass die Schicht aus dem organischen Halbleitermaterial vom n-Typ eine weitere n-dotierte Schicht ist. Mit Hilfe der n-Dotierung sind freie Ladungsträger in Form von Elektronen bereitgestellt.

Bei einer zweckmäßigen Ausgestaltung der Erfindung kann vorgesehen sein, dass die Schicht aus dem organischen Halbleitermaterial vom p-Typ eine weitere p-dotierte Schicht ist. Mit Hilfe der p-Dotierung sind freie Ladungsträger in Form von Löchern bereitgestellt.

Eine vorteilhafte Ausführungsform der Erfindung sieht vor, dass die Schicht aus dem organischen Halbleitermaterial vom p-Typ als mindestens eine Schichtart ausgewählt aus der folgenden Gruppe von Schichtarten gebildet ist: Löchertransportschicht und Elektronenblockschicht. Eine Löchertransportschicht ist dadurch charakterisiert, dass sie mit einer für den Transport der Löcher ausreichenden Beweglichkeit für die Löcher gebildet ist. In einer einfachen Ausführungsform ist die Schicht aus dem organischen Halbleitermaterial vom p-Typ eine Elektronenblockschicht, mit der der Transport von Elektronen in der Richtung zur Anode, unterbunden wird, wohingegen Ladungsträger in Form von Löchern transportiert werden. Diese Eigenschaften basieren auf unterschiedlichen energetischen Barrieren für den Transport von Elektronen und Löchern in der Elektronenblockschicht.

Bevorzugt sieht eine Fortbildung der Erfindung vor, dass die Schicht aus dem organischen Halbleitermaterial vom n-Typ als mindestens eine Schichtart ausgewählt aus der folgenden Gruppe von Schichtarten gebildet ist: Elektronentransportschicht und Löcherblockschicht. Eine Elektronentransportschicht ist dadurch charakterisiert, dass sie mit einer für den Transport der Elektronen ausreichenden Beweglichkeit für die Elektronen gebildet ist. In einer einfachen Ausführungsform ist die Schicht aus dem organischen Halbleitermaterial vom n-Typ, welche ihrerseits mit der leitenden Schicht der Kathode in Kontakt ist, eine Löcherblockschicht, mit der der Transport von Ladungsträgern in der organischen Schichtanordnung in einer Richtung von der Kathode weg blockiert wird, wohingegen elektrische Ladungsträger in Form von Elektronen weitergeleitet werden. Diese Eigenschaften basieren auf unterschiedlichen energetischen Barrieren für den Transport von Elektronen und Löchern in der Löcherblockschicht.

Bei einer vorteilhaften Ausgestaltung der Erfindung kann vorgesehen sein, dass die mindestens eine organische Schichtanordnung einen lichtemittierenden Bereich umfasst, welcher wahlweise ein- oder mehrschichtig ausgeführt ist. In dem lichtemittierenden Bereich rekombinieren die freien Ladungsträger, nämlich Elektronen und Löcher, unter Abgabe von Licht. In dem lichtemittierenden Bereich können ein oder mehrere Emittermaterialien angeordnet sein, wobei im Fall von mehreren Emittermaterialien diese Licht unterschiedlicher Farben abgeben können, wodurch in der Summe bevorzugt Weißlichter erzeugt wird.

Bei einer zweckmäßigen Ausgestaltung der Erfindung kann vorgesehen sein, dass die Schicht aus dem organischen Halbleitermaterial vom p-Typ als Teil des lichtemittierenden Bereiches gebildet ist. An die n-dotierte Schicht aus dem organischen Halbleitermaterial vom n-Typ schließt sich dann innerhalb der organischen Schichtanordnung direkt der lichtemittierende Bereich an.

Bevorzugt sieht eine Fortbildung der Erfindung vor, dass die Schicht aus dem organischen Halbleitermaterial vom n-Typ als Teil des lichtemittierenden Bereiches gebildet ist. An die p-dotierte Schicht aus dem organischen Halbleitermaterial vom p-Typ schließt sich dann innerhalb der organischen Schichtanordnung direkt der lichtemittierende Bereich an.

Eine zweckmäßige Fortbildung der Erfindung sieht vor, dass die Schicht aus dem organischen Halbleitermaterial vom n-Typ mehrschichtig gebildet ist.

Bei einer vorteilhaften Ausgestaltung der Erfindung kann vorgesehen sein, dass die Schicht aus dem organischen Halbleitermaterial vom p-Typ mehrschichtig gebildet ist.

Eine bevorzugte Weiterbildung der Erfindung sieht vor, dass das organische Halbleitermaterial vom p-Typ der p-dotierten Schicht aus dem organischen Halbleitermaterial vom p-Typ ein organisches Halbleitermaterial aus gewählt aus der folgenden Gruppe von organischen Halbleitermaterialien ist: Triarylamin, Phtalocyanin, metallorganische Komplexverbindung wie Kobaltocen, Metallkomplex wie Cr(hpp)₄, freies Radikal wie Pentaphenylcyclopentadienyl und organischer Reduktant wie Tetrathiafulvalen-Derivate oder amino-substituierte Polyzyklen.

Bei einer zweckmäßigen Ausgestaltung der Erfindung kann vorgesehen sein, dass das elektronische Bauelement als ein Bauelement ausgewählt aus der folgenden Gruppe von Bauelementen: organisches lichtemittierendes Bauelement, organische Diode, organische Solarzelle, organischer Transistor und organische lichtemittierende Diode implementiert wurde.

Es kann weiterhin vorgesehen sein, dass zwischen die Schichten aus dem p-dotierten organischen Halbleitermaterial vom p-Typ und dem organischen Halbleitermaterial vom n-Typ bzw. dem n-dotierten organischen Halbleitermaterial vom n-Typ und dem organischen Halbleitermaterial vom p-Typ eine dünne Zwischenschicht eingefügt wird. Eine solche Zwischenschicht kann beispielsweise aus einem Metall oder aus Akzeptoren und/oder Donoren bestehen. Die Zwischenschicht führt insbesondere zu einer Verbesserung der Stabilität des pn-Übergangs.

Zweckmäßig kann vorgesehen sein, dass das organische Halbleitermaterial vom n-Typ der n-dotierten Schicht aus dem organischen Halbleitermaterial vom n-Typ ein organisches Halbleitermaterial ausgewählt aus der folgenden Gruppe von organischen Halbleitermaterialien ist: Fullerene C60, Hexaazatriphenylene, insbesondere Hexanitrile Hexaazatriphenylene, und 1,3,4,5,7,8-Hexafluoronaphtho-2,6-chinontetracyanomethan.

### Beschreibung bevorzugter Ausführungsbeispiele der Erfindung

Die Erfindung wird im folgenden anhand von Ausführungsbeispielen unter Bezugnahme auf Figuren einer Zeichnung näher erläutert. Hierbei zeigen:
- Fig. 1: eine schematische Darstellung eines organischen elektronischen Bauelementes, bei dem zwischen einer Elektrode und einer Gegenelektrode eine organische Schichtanordnung in Kontakt mit der Elektrode und der Gegenelektrode angeordnet ist;
- Fig. 2: eine graphische Darstellung der Stromdichte in Abhängigkeit von der Spannung für verschiedene Ausführungsbeispiele eines organischen elektronischen Bauelementes;
- Fig. 3: eine graphische Darstellung der Leuchtdichte in Abhängigkeit von der Spannung für die verschiedenen Ausführungsformen des organischen elektronischen Bauelementes;
- Fig. 4: eine graphische Darstellung der Stromeffizienz in Abhängigkeit von der Leuchtdichte für die verschiedenen Ausführungsformen des organischen elektronischen Bau-elementes;
- Fig. 5: eine graphische Darstellung der Stromdichte und der Helligkeit in Abhängigkeit von der Spannung für ein Beispiel 10 eines organischen elektronischen Bauelements; und
- Fig. 6: eine graphische Darstellung der äußeren Quanteneffizienz in Abhängigkeit von der Helligkeit für das Beispiel 10.

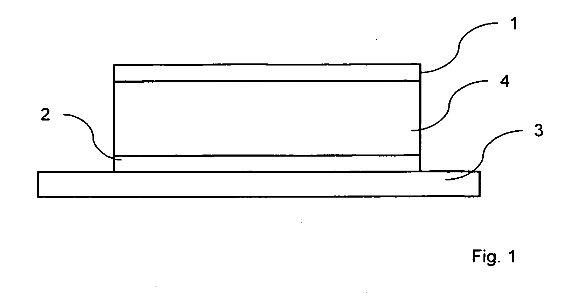

Fig. 1 zeigt eine schematische Darstellung eines organischen elektronischen Bauelementes, bei dem zwischen einer Elektrode 1 und einer Gegenelektrode 2, die auf einem Substrat 3 gebildet ist, eine organische Schichtanordnung 4 angeordnet ist, die ihrerseits in elektrischem Kontakt mit der Elektrode 1 und der Gegenelektrode 2. Über die Elektrode 1 und die Gegenelektrode 2, die von einer Anode und einer Kathode gebildet werden, kann eine elektrische Spannung an die organische Schichtanordnung 4 angelegt werden. Im Fall einer Ausführung als lichtemittierendes organisches elektronisches Bauelement führt das Anlegen der elektrischen Spannung dazu, dass freie Ladungsträger, nämlich Elektronen und Löcher, innerhalb der organischen Schichtanordnung 4 zu einem lichtemittierenden Bereich wandern und dort unter Abgabe von Licht miteinander rekombinieren.

In der folgenden Beschreibung von bevorzugten Ausführungsbeispielen werden die nachfolgend genannten Abkürzungen verwendet: ETL - Elektronentransportschicht, HTL - Löchertransportschicht, EBL - Elektronenblockschicht, HBL - Löcherblockschicht und EL - lichtemittierender Bereich.

Die organische Schichtanordnung 4 bei dem in Fig. 1 dargestellten organischen elektronischen Bauelement kann als Schichtstruktur in unterschiedlichen Ausgestaltungen aufgebaut sein. Vorteilhaft sind die nachfolgend genannten Schichtanordnungen:
- Anode / n-dotierte ETL / p-dotierte HTL / EBL / EL / HBL / n-dotierte ETL / p-dotierte HTL / Kathode
- Anode / n-dotierte ETL / p-dotiert HTL / EBL / EL / HBL / n-dotierte ETL / Kathode,
- Anode / p-dotierte HTL / EBL / EL / HBL / n-dotierte ETL / p-dotierte HTL / Kathode,
- Anode / n-dotierte ETL / EBL / EL / HBL / p-dotierte HTL / Kathode
- Anode / n-dotierte ETL / EBL / EL /HBL / n-dotierte ETL / Kathode
- Anode / p-dotierte HTL / EBL / EL / HBL / p-dotierte HTL / Kathode
- Kathode/ p-dotierte HTL / n-dotierte ETL/ HBL / EL / EBL / p-dotierte HTL / n-dotierte ETL / Anode
- Kathode / n-dotierte ETL / HBL / EL / EBL / p-dotierte HTL / n-dotierte ETL / Anode
- Kathode / p-dotierte HTL / n-dotiert ETL / HBL / EL / EBL / p-dotierte HTL / Anode
- Kathode / p-dotierte HTL / HBL / EL / EBL / n-dotierte ETL / Anode
- Kathode / n-dotierte ETL / HBL / EL / EBL / n-dotierte ETL / Anode
- Kathode / p-dotierte HTL / HBL / EL / EBL / p-dotierte HTL / Anode

In einigen Ausführungsformen können die Schichten HBL und / oder EBL weggelassen werden, beispielsweise dann, wenn die Schicht EL elektronentransportierend / löchertransportierend ausgeführt ist.

Bei den genannten Ausführungsformen ist stets mindestens ein pn- / np-Übergang gebildet, in welchem beim Anlegen einer elektrischen Spannung an die beiden Elektroden Ladungsträger erzeugt werden, nämlich Elektronen und Löcher. Die vorgenannten Ausführungen für die organische Schichtanordnung 4 können auch beliebig miteinander kombiniert werden, so dass auch zwei Übergänge in der organischen Schichtanordnung 4 gebildet sein können. Unter Einschluss jeweils mindestens eines pn- / np-Übergangs sind so ein oder mehrere ladungserzeugende Bereichen oder ladungserzeugende Schichten gebildet, beispielsweise: Anode / n-dotiert ETL / EBL / EL / HBL / p-dotiert HTL / Kathode oder Anode / n-dotiert ETL / p-dotiert HTL / EBL / EL / HBL / n-dotiert ETL / p-dotiert HTL / Kathode.

Es wurde gefunden, dass in einer einfachen Ausführungsform eine effiziente Ladungserzeugung zwischen der n-dotierten ETL und der EBL stattfindet. In analoger Weise wurde Ladungserzeugung zwischen der p-dotierten HTL und der HBL beobachtet.

In einfachen Ausführungsformen ist es vorteilhaft, wenn die energetische Differenz zwischen dem niedrigsten unbesetzten Molekülorbital (LUMO - *"Lowest Unoccupied Molecular Orbital"*) des Materials der n-dotierten ETL und dem höchsten besetzten Molekularorbital (HOMO - *"Highest Occupied Molecular Orbital"*) des Materials der EBL kleiner als 1.5eV, bevorzugt kleiner als 1.0eV und weiter bevorzugt kleiner als 0.5eV ist.

Ergänzend oder alternativ kann vorgesehen sein, dass die energetische Differenz zwischen dem HOMO des Materials der p-dotierten HTL und dem LUMO des Materials der HBL kleiner als 1.5eV, bevorzugt kleiner als 1.0eV und weiter bevorzugt kleiner als 0.5eV ist.

Nachfolgend werden Beispiele für organische elektronische Bauelemente gemäß dem in Fig. 1 schematisch dargestellten Aufbau mit unterschiedlichen Strukturen der organischen Schichtanordnung 4 näher erläutert. Die Bauelemente wurden hergestellt, indem die Materialien als Schichtstapel abgeschieden wurden, wobei die übliche Technologie der Vakuumverdampfung genutzt wurde.

In den nachfolgend beschriebenen Beispielen bezeichnen: ITO - Indium-Zinn-Oxid; A1 - Aluminium; STTB = 2,7- Tetra-(di-p-Tolylamin)-9,9'-spirobifluoren; Pdop - 1,3,4,5,7,8-Hexa-fluoronaphtho-2,6-chinontetracyanomethan; NPB - N,N'-di(naphthalene-2-yl)-N,N'-diphenyl-benzidine; Ndop - Tetrakis(1,2,3,3a,4,5,6,6a,7,8-decahydro-1,9,9b-triazaphenalenyl)di-tungsten(II); ETM -2,4,7,9-tetraphenyl phenanthroline: ORE - Iridium(III)bis(2-methyldi-benzo-[f,h]quinoxaline)(acetylacetonate); HTM - Tris(1-phenylisoquinoline) iridium (III); BPhen - Bathophenanthroline, HAT - hexanitrile hexaazatriphenylene

P-dop hat ein Reduktionspotential von etwa +0.2V vs. Fc/Fc⁺. NPB hat ein Oxidationspotential von etwa 0.3V vs. Fc/ Fc⁺. Ndop hat ein Oxidationspotential von etwa -2.2V vs Fc/ Fc⁺. ETM hat ein Reduktionspotential von etwa -2.2V vs. Fc/ Fc⁺. HTM hat ein Oxidationspotential von etwa 0.2 V vs. Fc/ Fc⁺. Fullerene C60 hat ein Reduktionspotential von etwa -1V vs.

Fc/ Fc⁺. STTB hat ein Oxidationspotential von etwa 0.1V vs. Fc/Fc⁺. HAT hat ein Reduktionspotential von etwa -0.6V vs. Fc/Fc⁺.

Hinsichtlich der verschiedenen Struktur bezeichnen allgemein: "p" eine p-dotierte Schicht, "i" eine undotierte Schicht (Isolator) und "n" eine n-dotierte Schicht.

### Beispiel 1

Als Beispiel 1 wurde als Referenz ein organisches elektronisches Bauelement mit einer herkömmlichen pin-Struktur hergestellt. Das Bauelement weist die folgende Schichtstruktur auf: Substrat: Glas / Anode: 90nm ITO / p-dotierte Schicht: 50nm Pdop in STTB (1,5 Gewichtsprozent) / intrinsische Schicht: 10nm NPB / intrinsische EL: 20nm ORE in NPB (10%) / intrinsische Zwischenschicht: 10nm ETM / n-dotierte Schicht: 55nm Ndop in ETM (8 Gewichtsprozent) / Kathode: 100nm Al.

### Beispiel 2 (nicht erfindungsgemäß)

Als Beispiel 2 wurde ein organisches elektronisches Bauelement mit einer npin-Struktur hergestellt: Glas / Anode: 90nm ITO / 45nm Ndop in ETM (8 Gewichtsprozent) / 5nm Pdop in HTM (1,5 Gewichtsprozent) / 10nm NPB / 20nm ORE in NPB (10%) / 10nm ETM / 55nm Ndop in ETM (8 Gewichtsprozent) / 100nm Al. Die Leitfähigkeit der Schicht aus Ndop in ETM beträgt etwa 2*10⁻⁵ S/cm

### Beispiel 3

Als weiteres Beispiel 3 wurde ein organisches elektronisches Bauelement mit folgender pinp-Schichtstruktur hergestellt: Glas / Anode: 90nm ITO / 50nm Pdop in STTB (1,5 Gewichtsprozent) / 10nm NPB / 20nm ORE in NPB (10%) / 10nm ETM / 55nm Ndop in ETM (8 Gewichtsprozent) / 5nm Pdop in HTM (1.5 Gewichtsprozent) / 100nm Al. Die Leitfähigkeit der Schicht aus Pdop in HTM beträgt etwa 4* 10⁻⁵ S/cm

### Beispiel 4

Weiterhin wurde als Beispiel 4 ein organisches elektronisches Bauelement mit folgendem Schichtaufbau hergestellt (npinp): Glas / Anode: 90nm ITO / 45nm Ndop in ETM (8 Gewichtsprozent) / 5nm Pdop in HTM (1,5 Gewichtsprozent) / 10nm NPB / 20nm ORE in NPB (10%) / 10nm ETM / 55nm Ndop in ETM (8 Gewichtsprozent) / 5nm Pdop in HTM (1.5 Gewichtsprozent) / 100nm Al.

### Beispiel 5

Weiterhin wurde als Beispiel 5 ein organisches elektronisches Bauelement mit folgendem Schichtaufbau hergestellt (pnipn): Glas / 90nm ITO/ 5nm Pdop in HTM (1.5 Gewichtsprozent)/ 45 nm Ndop in ETM (8 Gewichtsprozent)/ 10nm ETM/ 20nm ORE in NPB (10%)/10nm NPB/ 5nm Pdop im HTM (1,5 Gewichtsprozent)/ 55nm Ndop in ETM (8 Gewichtsprozent) / Anode: 100nm Al

### Beispiel 6 (nicht erfindungsgemäß)

Als Beispiel 6 wurde ein organisches elektronisches Bauelement mit einer vereinfachten Struktur wie folgt hergestellt: Glas / Anode: ITO / 1,3,4,5,7,8-Hexafluoronaphtho-2,6-chinontetracyanomethan dotiert mit Ndop(50nm) / NPD:ORE (20nm, 10 Gewichtsprozent) /BPhen (10nm) / BPhen:Cs (8:1, 60nm) / Al. Bei einer Betriebsspannung von 2,8V wurde eine Stromdichte von 10mA / cm² gemessen. Die elektrische Leitfähigkeit der Schicht aus 1,3,4,5,7,8-Hexafluoronaphtho-2,6-chinontetracyanomethan dotiert mit Ndop beträgt etwa g*10⁻⁵ S/cm

### Beispiel 7 (nicht erfindungsgemäß)

Als Beispiel 7 wurde zum Vergleich eine Struktur hergestellt: Glas / Anode: ITO /1,3,4,5,7,8-Hexafluoronaphtho-2,6-chinontetracyanomethan (50nm) / NPD: ORE (20nm, 10 Gewichtsprozent) / BPhen (10nm) / BPhen: Cs (60nm) / Al. Bei einer Betriebsspannung von 3,3V wurde eine Stromdichte von 10mA/cm² gemessen.

### Beispiel 8 (nicht erfindungsgemäß)

Als Beispiel 8 wurde ein organisches elektronisches Bauelement mit einer vereinfachten Struktur wie folgt hergestellt: Glas / Anode: ITO / HAT dotiert mit Ndop(50nm) / NPD: ORE (20nm, 10 Gewichtsprozent) / BPhen (10nm) / BPhen:Cs (8:1, 60nm) / Al. Bei einer Betriebsspannung von 4.4V wurde eine Stromdichte von 10mA / cm² gemessen. Die Leitfähigkeit der Schicht HAT dotiert mit Ndop beträgt etwa 5*10⁻⁵ S/cm

### Beispiel 9 (nicht erfindungsgemäß)

Als Beispiel 9 wurde weiterhin ein organisches elektronisches Bauelement mit dem folgenden Schichtaufbau hergestellt:
1. Transparentes Glassubstrat
2. Metallstreifen, Abstände 450 µm (Anode)
3. mit organischen donatorartigen Molekülen dotierte Fullerenschicht
4. nicht geschlossene Goldschicht, mittlere Dicke 1nm
5. Löchertransportschicht
6. Elektronenblockschicht
7. Licht emittierende Schicht
8. Löcherblockschicht
9. Elektronentransportschicht
10. Aluminiumkathode

Die Schichten 3. und 5., nämlich die mit organischen donatorartigen Molekülen dotierte Fullerenschicht und die Löchertransportschicht, bilden einen pn-Übergang, wobei zwischen diesen beiden Schichten die Schicht 4. als eine stabilisierende Metallschicht angeordnet ist.

### Beispiel 10 (nicht erfindungsgemäß)

Weiterhin wurde als Beispiel 10 ein organisches elektronisches Bauelement mit dem folgenden Schichtaufbau hergestellt:
20. Transparentes Glassubstrat
21. Chromstreifen, Abstände 450µm, Breiten 50µm, Dicke 10n (Anode)
22. 30nm C₆₀ dotiert mit 2 mol % [Ru (t-butyl-trpy)₂]⁰
23. nominell 1nm Gold (keine geschlossene Schicht)
24. 95nm MeO-TPD dotiert mit 4 mol % F4-TCNQ
25. 10nm Spiro-TAD
26. 20nm BA1q dotiert mit 20 Gewichts-% Ir(piq)₃
27. 10 nm BPhen
28. 65nm BPhen dotiert mit Cs
29. 100nm Al (Kathode)

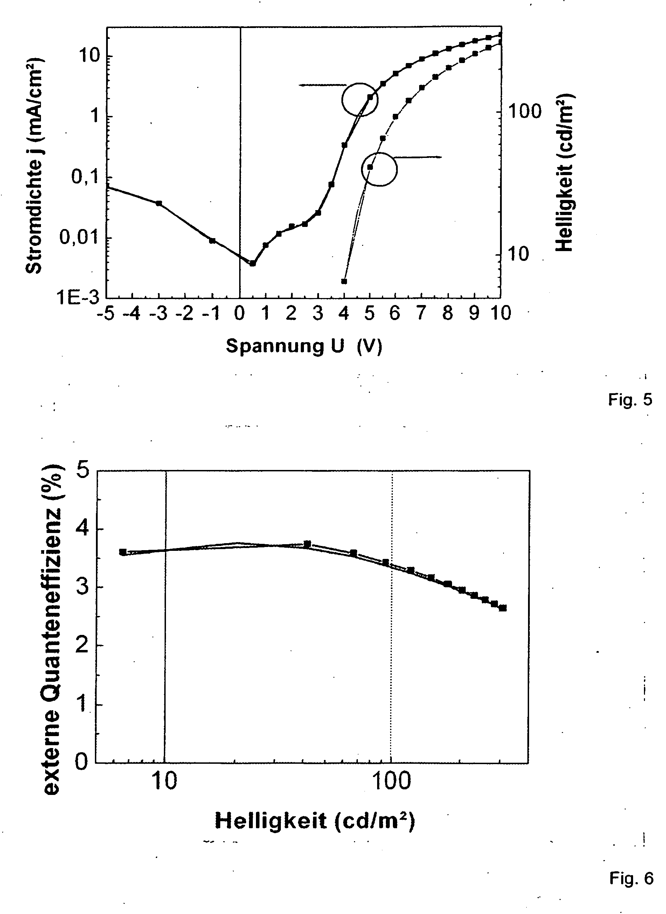

Bei diesem Ausführungsbeispiel bilden die Schichten 22. und 24. einen pn-Übergang, wobei zwischen den beiden Schichten als stabilisierende Metallschicht, die ihrerseits nicht geschlossen ist, die Schicht 23. aus Gold vorgesehen ist. Die elektrische Leitfähigkeit der Schicht 22 betrug weniger als 0,5 S/cm. Die Fig. 5 und 6 zeigen Daten zum Beispiel 10.

In den Beispielen 9 und 10 wird jeweils eine dotierte Schicht aus Fulleren verwendet. Fullerene, insbesondere das Buckminster-Fulleren C60, werden seit ihrer Entdeckung 1985 intensiv erforscht und kommen beispielsweise in organischen Solarzellen als Akzeptormaterial zum Einsatz (vgl. US 6,580,027 B2). In dem Dokument WO 92/04279 ist ein Verfahren zur Herstellung von C60 und C70 in größeren Mengen offenbart. Heutzutage stehen Fullerene als kostengünstige Ausgangsmaterialien zur Verfügung. Wie in WO 2005/086251 A2 erläutert, weisen Fulleren C60, die mit Dotanten versetzt werden, Leitfähigkeiten von über 2 S/cm auf. Die aus Fulleren gebildete Schicht wird vorzugsweise im Hochvakuum mittels gleichzeitigen Verdampfens des Fullerens und des organischen Dotanten, also mit dem für organische Dünnschichten üblichen Verfahren, aufgebracht. Somit fügt sich die Aufbringung eines solchen Fullerenschicht ohne Mehraufwand in den Produktionsprozess des organischen lichtemittierenden Bauelementes ein.

Organische Materialien, welche in den vorangehenden Beispielen 9 oder 10 verwendet wurden oder vorgesehen sein können, sind in folgender Tabelle aufgezählt:

| | |
|---|---|
| MeO-TPD N,N,N',N'-Tetrakis(4-methoxyphenyl)-benzidine | 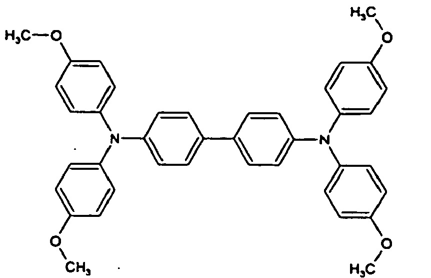 |
| Spiro-TAD 2,2',7,7'-Tetrakis-(N,N-diphenylamino)-9,9'-spirobifluoren | 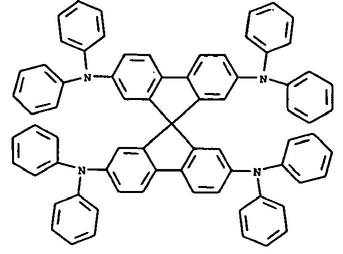 |
| BAlq Bis-(2-methyl-8-quinolinolato)-4-(phenyl-phenolato)-aluminium-(III) | 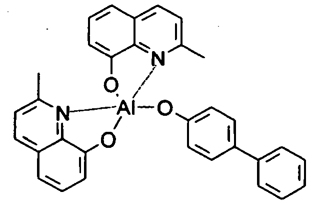 |
| Ir(piq)₃ Tris(1-phenylisoquinoline)iridium | 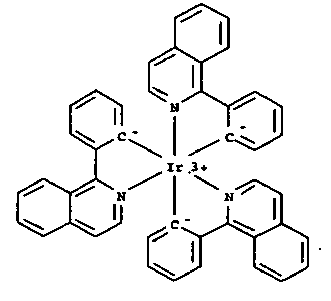 |
| Bphen 4,7-diphenyl-1,10-phenanthroline | 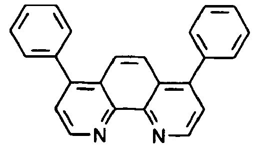 |
| [Ru(t-butyl-trpy)₂]⁰ | 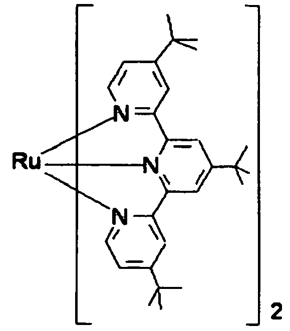 |
| AOB Acridine orange base | 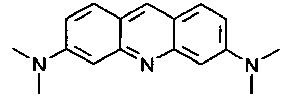 |

### Beispiel 11 nicht erfindungsgemäß

Weiterhin wurde als Beispiel 11 zum Vergleich ein organisches elektronisches Bauelement mit folgendem Schichtaufbau hergestellt (nip): Kathode ITO / 75nm ETM dotiert mit Ndop (9 Gewichtsprozent) / 10nm ETM / 20nm BA1q dotiert mit Ir(pic)3 (10 Gewichtsprozent) / 10nm NPB / 45nm STTB dotiert mit Pdop (6 Gewichtsprozent)/ Anode 100nm Al. Hierbei befindet sich die Kathode aus ITO auf einem transparenten Glassubstrat.

### Beispiel 12 nicht erfindungsgemäß

Weiterhin wurde als Beispiel 12 ein organisches elektronisches Bauelement mit folgendem Schichtaufbau hergestellt (nipn): Kathode ITO / 75nm ETM dotiert mit Ndop (9 Gewichtsprozent) / 10nm ETM/ 20nm BA1q dotiert mit Ir(pic)3 (10 Gewichtsprozent) / 10nm NPB /20nm STTB dotiert mit Pdop (6 Gewichtsprozent) / 25nm ETM dotiert mit Ndop (9 Gewichtsprozent) / Anode 100nm Al. Im Vergleich zu Beispiel 11 wurden eine geringe Betriebsspannung und eine höhere Stromeffizienz bei Verwendung eines pn-Übergangs in Verbindung mit der Anode gemessen.

### Beispiel 13 nicht erfindungsgemäß

Es wurde ein organisches elektronische Bauelement mit folgendem Schichtaufbau hergestellt: Anode: 90nm ITO / 50nm Pdop in STTB (1,5 Gewichtsprozent) / 10nm NPB / 20nm ORE in NPB (10%) / 10nm ETM / 10nm Ndop in ETM (8 Gewichtsprozent) / 5nm Pdop in HTM (1.5 Gewichtsprozent) / 40nm Pdop in STTB (1.5 Gewichtsprozent) / 100nm Al. Hierbei ist die p-dotierte Schicht vom p-Typ mehrschichtig ausgeführt, um die Stabilität des Bauelements zu verbessern.

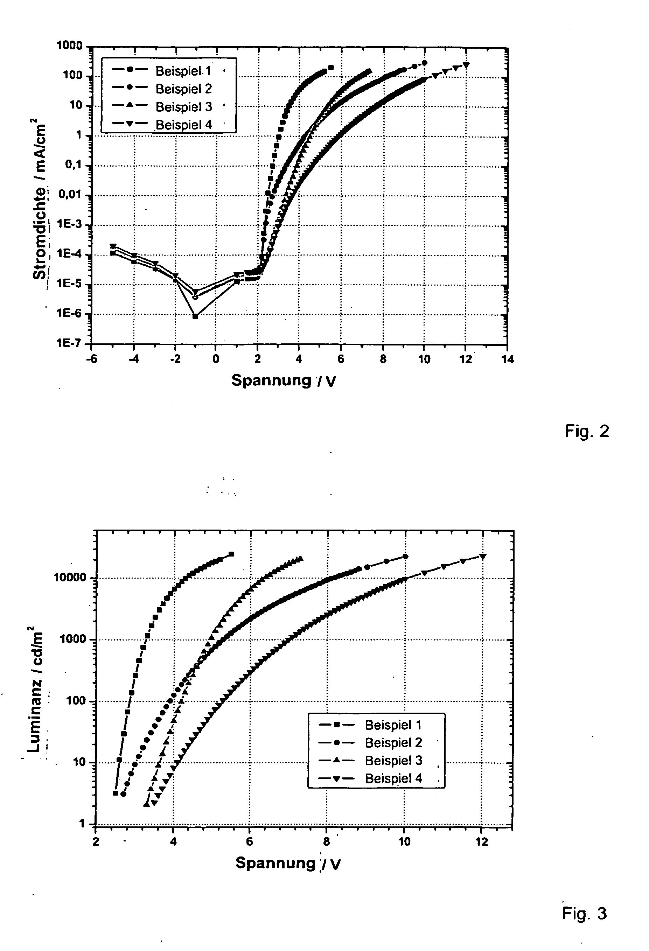

Fig. 2 zeigt eine graphische Darstellung der Stromdichte in Abhängigkeit von der Spannung für verschiedene Ausführungsbeispiele eines organischen Bauelementes.

Fig. 3 zeigt eine graphische Darstellung der Leuchtdichte in Abhängigkeit von der Spannung für die verschiedenen Ausführungsformen des organischen elektronischen Bauelementes.

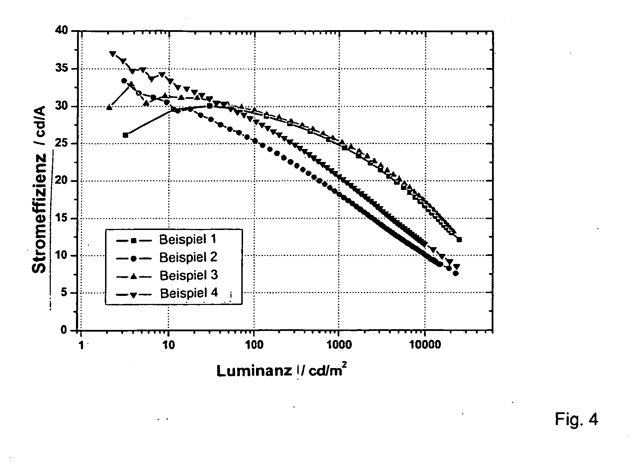

Fig. 4 zeigt eine graphische Darstellung der Stromeffizienz in Abhängigkeit von der Leuchtdichte für die verschiedenen Ausführungsformen des organischen elektronischen Bauelementes.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Elektronisches Bauelement, welches als organische Diode ausgeführt ist, mit einer eine leitende Schicht aufweisenden Anode, einer eine leitende Schicht aufweisenden Kathode und mindestens einer organischen Schichtanordnung, die zwischen der Anode und der Kathode angeordnet und in elektrischem Kontakt mit der Anode und der Kathode ist und einen Bereich mit einem pn-Übergang aufweist, welcher konfiguriert ist, beim Anlegen des elektrischen Potentials an die Anode und die Kathode benachbart zu der Kathode elektrische Landungen zu erzeugen, und welcher mit einer Schicht aus einem organischen Halbleitermaterial vom n-Typ und einer p-dotierten Schicht aus einem organischen Halbleitermaterial vom p-Typ gebildet ist, wobei die p-dotierte Schicht mit der leitenden Schicht der Kathode in Kontakt ist.

2. Bauelement nach Anspruch 1, **dadurch gekennzeichnet, dass** die organische Schichtanordnung einen Bereich mit einem np-Übergang aufweist, welcher konfiguriert ist, beim Anlegen eines elektrischen Potentials an die Anode und die Kathode benachbart zu der Anode elektrische Ladungen zu erzeugen, und welcher mit einer Schicht aus einem organischen Halbleitermaterial vom p-Typ und einer n-dotierten Schicht aus einem organischen Halbleitermaterial vom n-Typ gebildet ist, wobei die n-dotiertc Schicht mit der leitenden Schicht der Anode in Kontakt ist.

3. Bauelement nach Anspruch 1 oder 2, **dadurch gekennzeichnet, dass** die Schicht aus dem organischen Halbleitermaterial vom n-Typ im Bereich des pn-Übergangs eine n-dotierte Schicht ist.

4. Bauelement nach Anspruch 2, **dadurch gekennzeichnet, dass** die Schicht aus dem organischen Halbleitermaterial vom p-Typ im Bereich des np-Übergangs eine p-dotierte Schicht ist.

5. Bauelement nach einem der vorangehenden Ansprüche, **dadurch gekennzeichnet, dass** die Schicht aus dem organischen Halbleitermaterial vom n-Typ als mindestens eine Schichtart ausgewählt aus der folgenden Gruppen von Schichtarten gebildet ist: Elektronentransportschicht und Löcherblockschicht.

6. Bauelement nach einem der vorangehenden Ansprüche, **dadurch gekennzeichnet, dass** die Schicht aus dem organischen Halbleitermaterial vom p-Typ als mindestens eine Schichtart ausgewählt aus der folgenden Gruppen von Schichtarten gebildet ist: Löchertransportschicht und Elcktronenblockschicht.

7. Bauelement nach einem der vorangehenden Ansprüche, **dadurch gekennzeichnet, dass** die mindestens eine organische Schichtanordnung einen lichtemittierenden Bereich aufweist, der ein- oder mehrschichtig ausgeführt ist

8. Bauelement nach Anspruch 7, **dadurch gekennzeichnet, dass** die Schicht aus dem organischen Halbleitermaterial vom p-Typ als Teil des lichtemittiercnden Bereiches gebildet ist.

9. Bauelement nach Anspruch 7 oder 8, **dadurch gekennzeichnet, dass** die Schicht aus dem organischen Halbleitermaterial vom n-Typ als Teil des lichtemittiereoden Bereiches gebildet ist.

10. Bauelement nach einem der vorangehenden Ansprüche, **dadurch gekennzeichnet, dass** die Schicht aus dem organischen Halbleitermaterial vom n-Typ mehrschichtig gebildet ist.

11. Bauelement nach einem der vorangehenden Ansprüche, **dadurch gekennzeichnet, dass** die Schicht aus dem organischen Halbleitermaterial vom p-Typ mehrschichtig gebildet ist.

12. Bauelement nach einem der vorangehenden Ansprüche, **dadurch gekennzeichnet, dass** das organische Halbleitermaterial vom p-Typ der p-dotierten Schicht ein organisches Halbleitermaterial ausgewählt aus der folgenden Gruppe von organischen Halbleitermaterialien ist: Triarylamin, Phtalocyanin, metallorganische Komplexverbindung wie Kobaltocen, Metallkomplex wie Cr(hpp)₄, freies Radikal wie Pentaphenylcyclopentadienyl und organischer Reduktant wie Tetrathiafulvalen-Derivate oder amino-substituierte Polyzyklen.

13. Bauelement nach einem der vorangehenden Ansprüche, soweit auf Anspruch 7 rückbezogen, implementiert als organische lichtemittierende Diode.

14. Bauelement nach einem der Ansprüche 1 bis 12, soweit nicht auf die Ansprüche 7-9 rückbezogen, implementiert als organische Solarzelle.

## Claims

1. Electronic component, which is formed as organic diode, with an anode comprising a conductive layer, a cathode comprising a conductive layer and at least one organic layer arrangement, which is arranged between the anode and the cathode and which is in electrical contact with the anode and the cathode and comprising a region with a pn-junction, which is configured to generate electrical charges proximal to the cathode when the electric potential is applied to the anode and the cathode and which is formed with a layer of an n-type organic semiconductor material and a p-doped layer of a p-type organic semiconductor material, wherein the p-doped layer is in contact with the conductive layer of the cathode.

2. Component according to claim 1, **characterized in that** the organic layer arrangement comprises a region with a pn-junction, which is configured to generate electrical charges proximal to the anode, when an electric potential is applied to the anode and the cathode, and which is formed with a layer of a p-type organic semiconductor material and an n-doped layer of an n-type semiconductor material, wherein the n-doped layer is in contact with the conductive layer of the anode.

3. Component according to claim 1 or 2, **characterized in that** the layer of n-type organic semiconductor material in the region of the pn-junction is an n-doped layer.

4. Component according to claim 2, **characterized in that** the layer of p-type organic semiconductor material in the region of the pn-junction is a p-doped layer.

5. Component according to one of the preceding claims, **characterized in that** the layer of n-type organic semiconductor material is formed as at least one layer type selected from the following groups of layer types: electron transport layer and hole blocking layer.

6. Component according to one of the preceding claims, **characterized in that** the layer of p-type organic semiconductor material is formed as at least one layer type selected from the following groups of layer types: hole transport layer and electron blocking layer.

7. Component according to one of the preceding claims, **characterized in that** the at least one organic layer arrangement comprises a light-emitting zone, which is formed as a single-layer or multilayer.

8. Component according to claim 7, **characterized in that** the layer of p-type organic semiconductor material is formed as part of the light-emitting zone.

9. Component according to claim 7 or 8, **characterized in that** the layer of n-type organic semiconductor material is formed as part of the light-emitting zone.

10. Component according to one of the preceding claims, **characterized in that** the layer of n-type organic semiconductor material is formed as a multilayer construction.

11. Component according to one of the preceding claims, **characterized in that** the layer of p-type organic semiconductor material is formed as a multilayer construction.

12. Component according to one of the preceding claims, **characterized in that** the p-type organic semiconductor material of the p-doped layer is an organic semiconductor material selected from the following group of organic semiconductor materials: triarylamine, phthalocyanine, an organometallic complex compound such as cobaltocene, a metal complex such as Cr(hpp)₄, a free radical such as pentaphenylcyclopentadienyl and an organic reducing agent such as tetrathiafulvalene derivatives or amino-substituted polycycles.

13. Component according to one of the preceding claims, as reference is made to claim 7, wherein the component is implemented as an organic light limitting device.

14. Component according to one of the claims 1 to 12, as reference is not made to the claims 7 - 9, wherein the component is implemented as an organic solar cell.

## Revendications

1. Composant électronique, qui est réalisé sous forme de diode organique, comprenant une anode présentant une couche conductrice, une cathode présentant une couche conductrice et au moins un agencement de couche organique, qui est disposé entre l'anode et la cathode et est en liaison électrique avec l'anode et la cathode et présente une zone avec une transition pn, laquelle est configurée pour générer des charges électriques à proximité de la cathode lors de l'application du potentiel électrique sur l'anode et la cathode, et qui est formée avec une couche à base d'un matériau semi-conducteur organique du type n et une couche dopée p à base d'un matériau semi-conducteur organique du type p, la couche dopée p étant en contact avec la couche conductrice de la cathode.

2. Composant selon la revendication 1, **caractérisé en ce que** l'agencement de couche organique présente une zone avec une transition np, qui est configurée pour générer des charges électriques à proximité de l'anode lors de l'application d'un potentiel électrique sur l'anode et la cathode, et qui est formée avec une couche à base d'un matériau semi-conducteur organique du type p et une couche dopée n à base d'un matériau semi-conducteur organique du type n, la couche dopée n étant en contact avec la couche conductrice de l'anode.

3. Composant selon la revendication 1 ou 2, **caractérisé en ce que** la couche est à base du matériau semi-conducteur organique du type n dans la zone de la transition pn d'une couche dopée n.

4. Composant selon la revendication 2, **caractérisé en ce que** la couche à base du matériau semi-conducteur organique du type p dans la zone de la transition np est une couche dopée p.

5. Composant selon l'une des revendications précédentes, **caractérisé en ce que** la couche à base du matériau semi-conducteur organique du type n est formée comme au moins un type de couche sélectionné dans les groupes suivants de types de couche : couche de transport d'électrons et couche bloc à trous.

6. Composant selon l'une des revendications précédentes, **caractérisé en ce que** la couche à base du matériau semi-conducteur organique du type p est formée comme au moins un type de couche sélectionné parmi les groupes suivants de types de couche : couche de transport à trous et couche bloc à électrons.

7. Composant selon l'une des revendications précédentes, **caractérisé en ce que** le au moins un agencement de couche organique présente une zone émettrice de lumière, qui est réalisée avec une couche ou plusieurs couches.

8. Composant selon la revendication 7, **caractérisé en ce que** la couche à base du matériau semi-conducteur organique du type p est formée comme partie de la zone émettrice de lumière.

9. Composant selon la revendication 7 ou 8, **caractérisé en ce que** la couche à base du matériau semi-conducteur organique du type n est formée comme partie de la zone émettrice de lumière.

10. Composant selon l'une des revendications précédentes, **caractérisé en ce que** la couche à base du matériau semi-conducteur organique du type n est formée avec plusieurs couches.

11. Composant selon l'une des revendications précédentes, **caractérisé en ce que** la couche à base du matériau semi-conducteur organique du type p est formée avec plusieurs couches.

12. Composant selon l'une des revendications précédentes, **caractérisé en ce que** le matériau semi-conducteur organique du type p de la couche dopée p est un matériau semi-conducteur organique sélectionné dans le groupe suivant de matériaux semi-conducteurs organiques : triarylamine, phtalocyanine, composé complexe organométallique tel que cobaltocène, complexe métallique tel que Cr(hpp)₄, radical libre tel que pentaphénylcyclopentadiényle et réductant organique tel que des dérivés de tétrathiafulvalène ou polycycles amino-substitués.

13. Composant selon l'une des revendications précédentes, si rapportée à la revendication 7, mis en place sous forme de diode électroluminescente organique.

14. Composant selon l'une des revendications 1 à 12, si non rapportée aux revendications 7-9, mis en place sous forme de cellule solaire organique.
